# EUROPEAN PATENT APPLICATION

(11) **EP 1 111 665 A2**
(43) Date of publication of application: **27.06.2001**
(21) Application number: 00311569.8
(22) Date of filing: 21.12.2000
(51) Int. Cl.: H01L 21/321, B24B 7/04

(54) **Method of planarizing a substrate surface**

(30) Priority: 21.12.1999 US 469709
(71) Applicant: Applied Materials, Inc., Santa Clara, California 95054 (US)
(72) Inventor: Li, Shijian, San Jose, CA 95129 (US); Redeker, Fred C., Fremont, CA 94539 (US); White, John M., Hayward, CA 94541 (US); Emani, Ramin, San Jose, CA 95126 (US)
(74) Representative: Bayliss, Geoffrey Cyril

(57) **Abstract**

High through-put Cu CMP is achieved with reduced erosion and dishing by a multi-step polishing technique. Deposited Cu (13) is polished with fixed abrasive polishing pads initially at a high removal rate and subsequently at a reduced removal rate and high Cu: barrier layer (ta) (12) selectively. Buffing is then conducted to remove the barrier layer. Embodiments of the present invention include reducing dishing by: controlling platen rotating speeds; increasing the concentration of active chemicals; and cleaning the polishing pads between wafers. Embodiments also include removing particulate material during CMP by increasing the flow rate of the chemical agent or controlling the static etching rate between about 100 and about 150A per minute, and recycling the chemical agent. Embodiments further include flowing and inhibitor across the wafer surface after each CMP step to reduce the static etching rate.

## Description

The invention relates to copper (Cu) and/or copper alloy metallization in semiconductor devices with improved planarity.

The escalating requirements for high density and performance associated with ultra large scale integration semiconductor wiring require responsive changes in interconnect technology. Such escalating requirements have been found difficult to satisfy in terms of providing a low RC (resistance and capacitance) interconnect pattern, particularly in applications where submicron vias, contacts and trenches have high aspect ratios imposed by miniaturization.

Conventional semiconductor devices comprise a semiconductor substrate, typically doped monocrystalline silicon, and a plurality of sequentially formed dielectric layers and conductive patterns. An integrated circuit is formed containing a plurality of conductive patterns comprising conductive lines separated by interwiring spacings, and a plurality of interconnect lines. Typically, the conductive patterns on different layers, *i.e.*, are electrically connected by a conductive plug filling a via hole, while a conductive plug filling a contact hole establishes electrical contact with an active region on a semiconductor substrate, such as a source/drain region. Conductive lines are formed in trenches which typically extend substantially horizontal with respect to the semiconductor substrate. Semiconductor "chips" comprising five or more levels of metallization are becoming more prevalent as device geometries shrink to submicron levels.

A conductive plug filling a via hole is typically formed by depositing a dielectric layer on a conductive layer comprising at least one conductive pattern, forming an opening through the dielectric layer by conventional photolithographic and etching techniques, and filling the opening with a conductive material, such as tungsten (W). Excess or overburden conductive material on the surface of the dielectric interlayer is typically removed by chemical mechanical polishing (CMP). One such method is known as damascene and basically involves forming an opening in the dielectric interlayer and filling the opening with a metal. Dual damascene techniques involve forming an opening comprising a lower contact or via hole section in communication with an upper trench section. The entire opening is filled with a conductive material, typically a metal, to simultaneously form a conductive plug in electrical contact with a conductive line.

Copper (Cu) and copper alloys have received considerable attention as candidates for replacing aluminum (Al) in interconnect metallization. Copper and copper alloys are relatively inexpensive, easy to process, and have a lower resistivity than aluminum. In addition, copper and copper alloys have improved electrical properties, *vis-à-vis* tungsten (W), making copper and copper alloys desirable metals for use as a conductive plug as well as conductive wiring.

An approach to forming copper and copper alloy plugs and wiring comprises the use of damascene structures. However, due to copper diffusion through dielectric layer materials, such as silicon dioxide, a diffusion barrier layer for copper interconnect structures is provided between copper or copper alloy interconnect structures and surrounding dielectric materials. Typical diffusion barrier metals include tantalum (Ta), tantalum nitride (TaN), titanium nitride (TiN), titanium-tungsten (TiW), tungsten (W), tungsten nitride (WN), titanium-titanium nitride (Ti-TiN), titanium silicon nitride (TiSiN), tungsten silicon nitride (WSiN), tantalum silicon nitride (TaSiN) and silicon nitride for copper and copper alloys. The use of such barrier materials to encapsulate copper is not limited to the interface between copper and the dielectric interlayer, but includes interfaces with other metals as well.

In conventional polishing techniques, a substrate carrier assembly is rotated in contact with a polishing pad in a polishing apparatus. The polishing pad is mounted on a rotating turntable or platen, or moving above a stationary polishing table, driven by an external driving force. The substrates are typically mounted on a carrier which provides a controllable pressure urging the substrates against the polishing pad. Thus, the CMP apparatus effects polishing or rubbing movement between the surface of each thin semiconductor substrate and the polishing pad while dispersing a polishing chemical with or without abrasive particles in a reactive solution to effect both chemical activity and mechanical activity while applying a force between the substrate and a polishing pad.

Conventional polishing pads employed in abrasive slurry processing typically comprise a grooved porous polymeric surface, such as polyurethane, and the abrasive slurry varied in accordance with the particular material undergoing polishing. Basically, the abrasive slurry is impregnated into the pores of the polymeric surface while the grooves convey the abrasive slurry to the substrate undergoing polishing. A polishing pad for use in CMP slurry processing is disclosed by Krywanczyk et al. in U.S. Patent 5,842,910.

A distinctly different type of abrasive article from the above-mentioned abrasive slurry-type polishing pad is a fixed abrasive article, *e.g.*, fixed abrasive polishing pad. Such a fixed abrasive article typically comprises a backing sheet with a plurality of geometric abrasive composite elements adhered thereto. The abrasive elements typically comprise a plurality of abrasive particles in a binder, *e.g.*, a polymeric binder. During polishing employing a fixed abrasive article, the substrate or substrate undergoing CMP wears away the fixed abrasive elements thereby maintaining exposure of the abrasive particles. Accordingly, during polishing employing a fixed abrasive article, a chemical agent is dispersed to provide the chemical activity, while the mechanical activity is provided by the fixed abrasive elements and abrasive particles exposed by abrasion with the substrate undergoing polishing. Fixed abrasive articles are disclosed by Rutherford et al. in U.S. Patent No. 5,692,950. Calhoun in U.S. Patent No. 5,820,450, Haas et al. in U.S. Patent No. 5,453,312 and Hibbard et al. in U.S. Patent No. 5,454,844.

It is extremely difficult to planarize a copper or copper alloy surface, as by polishing of a damascene inlay, to achieve a high degree of surface planarity, particularly across a surface extending over a dense array of copper or copper alloy features and the field of a substrate surface. A dense array of copper or copper alloy features is typically formed in a dielectric layer, such as a silicon oxide layer, by a damascene technique wherein trenches are initially formed. A barrier layer, such as a tantalum-containing layer, *e.g.*, tantalum (Ta), or tantalum nitride (TaN), is then conformally deposited on the exposed surfaces of the trenches and on the upper surface of the dielectric layer. Copper or a copper alloy is then deposited, as by electroplating, electroless plating, physical vapor deposition (PVD) or chemical vapor deposition (CVD) on the barrier layer, typically at a thickness between about 8.000Å and about 18,000 Å.

Polishing is then conducted to remove the copper or copper alloy overburden and stopping on the barrier layer, followed by barrier layer removal, by employing a mixture of a chemical agent and abrasive particles, to remove the copper or copper alloy and barrier layer to the dielectric layer. Copper or copper alloy overburden is material deposited on the substrate in excess of the required amount to fill features formed on the substrate surface.

Erosion and dishing are typically encountered in planarizing the substrate surface after a copper metallization process. Dishing is the formation of topographical defects, such as concavities or depressions, in the copper and copper alloy layer of features formed on the substrate surface. Dishing further results in a non-planar surface that impairs the ability to print high resolution lines during subsequent photolithographic steps and detrimentally affects subsequent surface topography of the substrate and device formation. Dishing also detrimentally affects the performance of devices by lowering the conductance and increasing the resistance of the devices, contrary to the benefit of using higher conductive materials, such as copper. Dishing can further lead to non-uniform removal of the barrier layer in subsequent polishing steps. Erosion is the excessive removal of dielectric material surrounding features formed on the substrate surface.

There exists a need for high-production through-put polishing of copper or copper alloy with minimal or reduced erosion and dishing of the substrate surface, thereby achieving a high degree of surface planarity.

Aspects of the invention generally provide a method and composition for planarizing a substrate surface including planarizing metals, such as copper and copper alloys, with reduced surface defects and surface corrosion.

In one aspect, the invention provides a method of planarizing a substrate surface comprising polishing the substrate surface on a first platen to reduce a copper or copper alloy layer disposed thereon at a first removal rate and polishing the substrate on a second platen to remove the copper or copper alloy layer at a second removal rate, less than the first removal rate.

In another aspect, a computer readable medium is provided bearing instructions, the instructions arranged, when executed by one or more processors, to cause one or more processors to control a polishing system to polish the substrate surface at a first removal rate on a first platen and then polish the substrate surface at a second removal rate less than the first removal rate on a second platen.

So that the manner in which the above recited features, advantages and objects of the present invention are attained and can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefore not to be considered limiting of its scope, for the invention may admit to other equally effective embodiments.

Figs. 1-4 illustrate sequential phases of a method in accordance with an embodiment of the present invention.

Fig. 5 depicts a block diagram of a computer system configured for controlling a CMP system in accordance with an embodiment of the invention.

Embodiments of the invention described herein enable effective planarization of a substrate surface having copper or copper alloy containing features at high production through-put with reduced or minimal erosion and dishing, consistent with the ever increasing demands for reliable interconnect patterns having feature sizes in the submicron range. As used throughout this disclosure, copper (Cu) is intended to encompass high purity elemental copper as well as copper-based alloys, *e.g.*, copper-based alloys containing at least about 80 wt.% copper.

Embodiments of the invention described herein can be advantageously used in a multi-step process including sequential polishing steps with minimal or reduced dishing and erosion. The polishing step can stop on the barrier layer and may be used in a fixed abrasive polishing technique. An abrasive slurry can then be used in a polishing process to remove the barrier layer.

The multi-step methodology of the present invention stems from a study of the factors impacting erosion and dishing in planarizing a dense array of copper or copper alloy features, *e.g.*, lines, bordered by an open field. The expression "dense array" is intended to encompass metal features spaced apart by a variety of distances less than about 100 microns, while the expression "open field" is intended to encompass a field extending in excess of about 100 microns without a metal feature.

Embodiments of the present invention include a multi-step process comprising polishing the substrate surface at a first removal rate to remove most of the bulk copper or copper alloy overburden and polishing the substrate surface at a second removal rate less than the first removal rate. The polishing technique having the second removal rate may have a high selectivity to a subsequent barrier layer to stop thereon.

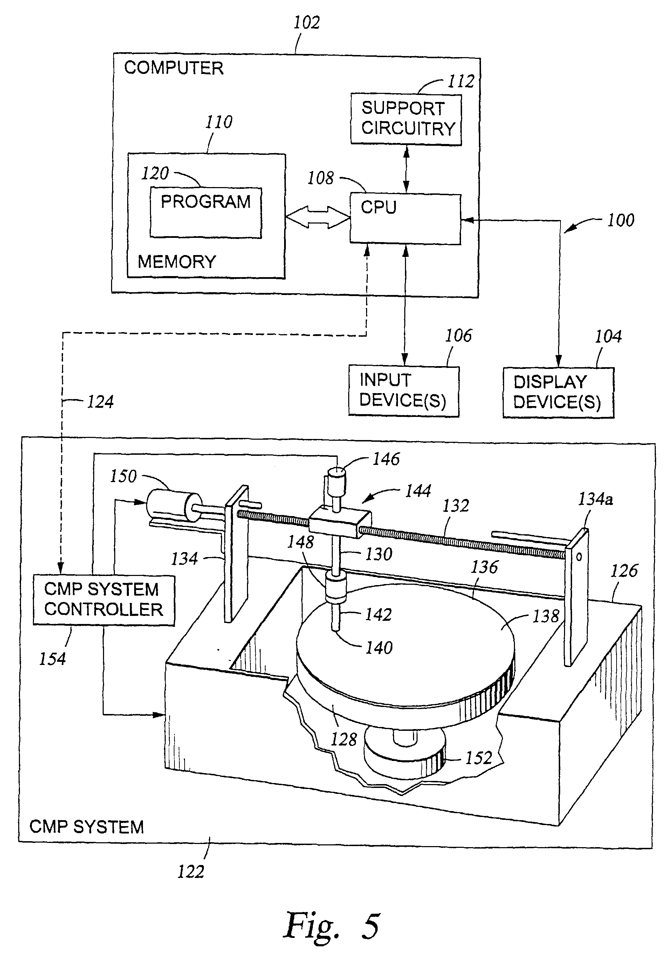

The polishing steps are performed on a first and second rotating, stationary, or linear platen, respectively, and both polishing processes employing a fixed abrasive polishing pad or a conventional, non-fixed abrasive poishing pad using an abrasive or abrasive-free chemical agent. An example of a suitable chemical mechanical polishing apparatus capable of polishing a substrate surface according to the processes described herein is shown in Figure 5 and described in more detail below.

Barrier layer materiaks, such as tantalum or tantalum nitride, may be removed on a third rotating, stationary, or linear polishing pad using an abrasive slurry. Suitable barrier removal techniques are disclosed in co-pending U.S. patent application Serial No. 09/401,643 filed on September 22, 1999, and in co-pending U.S. patent application Serial No. 09/569,968 filed on May 11, 2000, the entire disclosures of which are incorporated by reference herein to the extent not inconsistent with the invention. The dielectric layer may be buffed to reduce or eliminate scratching and defects on the substrate surface.

Embodiments of the processes described herein may be used to planarize a copper or copper alloy metal film by a multi-step process to minimize or reduce erosion and dishing of the substrate surface. Minimizing or reducing erosion and dishing of the substrate surface enables the use of conventional photolithography to form metal features having dimensions in the deep submicron range, *i.e.*, less than about 0.2 microns, such as about 0.1 microns.

A typical copper metallization or interconnect system includes depositing a dielectric layer overlying a substrate, forming an opening, *i.e.*, a damascene opening, in the dielectric layer, depositing a diffusion barrier, such as a tantalum containing material, *i.e.*, TaN or Ta, and filling the opening with copper or copper alloy. Advantageously, the opening in the dielectric layer can be filled by initially depositing a seedlayer and then electroplating or electroless plating the copper or copper alloy layer, typically at a thickness between about 8,000 and about 18,000Å. The damascene openings can also be filled with copper or copper alloy by PVD at a temperature between about 50°C and about 150°C or by CVD at a temperature under about 200°C.

Conventional substrates and dielectric materials are encompassed by the present invention. For example, the substrate can be doped monocrystalline silicon or gallium-arsenide. The dielectric layer can comprise any of various dielectric materials conventionally employed in the manufacture of semiconductor devices. For example, dielectric materials, such as silicon dioxide, phosphorus-silicate-glass (PSG), boron doped phosphorus-silicate-glass (BPSG) and silicon dioxide derived from tetraethyl orthosilicate (TEOS) or silane by plasma enhanced chemical vapor deposition (PECVD) can be employed. Dielectric layers in accordance with the present invention can also comprise low dielectric constant materials, including polymers, such as polyimides, and carbon-containing silicon dioxide, *e.g.*, Black Diamond® available from Applied Materials, Inc., located in Santa Clara, California. The openings are formed in dielectric layers by conventional photolithographic and etching techniques.

The copper or copper alloy metallized substrate surface is first polished at a first removal rate to effect bulk copper or bulk copper alloy removal. The substrate is polished on a polishing pad mounted on a rotating, stationary, or linear platen. The first removal rate is a relatively high removal rate for rapid through-put, *e.g.*, a removal rate greater than about 5,000Å per minute. The copper or copper alloy metallized surface is polished down to a thickness between about 500Å and about 3,000Å. CMP essentially involves a combination of chemical action and mechanical abrasion.

The polishing process includes a chemical action which oxidizes the surface of the metal, *i.e.*, copper or copper alloy, which can then be mechanically abraded by the polishing pad, for example, by fixed abrasive elements or posts disposed in the polishing pad. Given the guidance disclosed herein and the disclosed objectives, suitable polishing conditions and chemical agents can be readily determined in a particular situation.

Suitable chemical agents can include sodium chromate tetrahydrate as disclosed by Carpio in U.S. Patent No. 5,840,629, and/or a carboxylate salt, such as ammonium citrate, as disclosed by Watts et al. in U.S. Patent No. 5,897,375. Advantageously, an inhibitor, such as a triazole or a triazole derivative, *e.g.*, 1,2, 4-triazole or benzotriazole, can be employed. The chemical agent can also include a solvent, such as deionized water or an alcohol.

For example, in a copper metallization including a silicon dioxide dielectric layer and TaN barrier layer, the chemical agent of the first polishing process can include between about 0.5 and wt.% about 10 wt.% of an oxidizer, *e.g.,* about 6 wt.%, such as hydrogen peroxide, between about 0.05 wt.% and about 0.20 wt.% of an inhibitor, *e.g.*, about 0.15 wt.%, such as 5-methyl benzotriazole, between about 0.5 wt.% and about 5.0 wt.% *e.g.*, about 3 wt.%, of a chelating agent, such as iminodiaetic acid, and between about 3.0 wt.% and about 15.0 wt.%, *e.g.*, about 9.0 wt.%, of another chelating agent, such as ammonium hydrogen phosphate, the balance deionized water. The pressure is typically about 3 psi but may vary on the composition and desired removal rate. In polishing the bulk copper or copper alloy layer in the first polishing step, it was found suitable to formulate the polishing composition such that it has a pH and oxidation-reduction potential in the domain of passivation of Cu. A pH between about 3 and about 10, such as a pH between about 5 and about 8 is used in some aspects of the composition. Other suitable chemical agents are described in co-pending U.S. Application Serial No. 09/543,777, filed on April 5, 2000, and in co-pending U.S. Application Serial No. 09/544,281, filed on April 6, 2000.

The concentration of the inhibitor can be strategically adjusted throughout the polishing steps of the invention to control the static removal rate. For example, the static removal rate can be decreased by increasing the amount of inhibitor, thereby reducing chemical complexing of copper or copper alloy by chelating components of the chemical agent.

The remainder of the bulk copper or copper alloy overlying the barrier layer, or residual copper or copper alloy, typically includes a thickness between about 500Å and about 3,000Å. The residual copper or copper alloy is removed by a second polishing process by polishing the substrate on a rotating, stationary or linear polishing pad, such as a fixed abrasive polishing pad, and employing a chemical agent with high selectivity to and stopping on a tantalum containing barrier layer, such as tantalum or tantalum nitride.

The second polishing process is conducted at a second removal rate less than the first polishing step. The second removal rate is between about 250 Å per minute and about 3,000 Å per minute. The second removal rate can also be reduced from the first removal rate by suitable adjustment of conditions, such as reduced pressure, *e.g.*, employing a pressure no greater than about 3 psi. The second removal rate can be made less than the first removal rate by employing a chemical agent including between about 0.3 wt.% and about 6.0 wt.%, *e.g*., about 3 wt.%, of an oxidizer, such as hydrogen peroxide, between about 0.03 wt.% and about 0.5 wt.%, *e.g.*, about 0.06 wt.%, of an inhibitor, *e.g.* 5-methyl-benzotriazole, between about 0.25 wt.% and about 5.0 wt.% *e.g.*, about 1.0 wt.%, of a chelating agent, *e.g.*, iminodiacetic acid, between about 1.0 wt.% and about 6 wt.%, *e.g.*, about 3 wt.% of another chelating agent, such as ammonium hydrogen phosphate, the balance deionized water. The pressure is typically about 2 psi, but my vary on the composition and desired removal rate. In polishing the copper or copper alloy layer in the second polishing step, it was found suitable to formulate the polishing composition such that it has a pH and oxidation-reduction potential in the domain of passivation of Cu. A pH between about 3 and about 10, such as a pH between about 5 and about 8 is used in some aspects of the composition. Other suitable chemical agents are described in co-pending U.S. Application Serial No. 09/543,777, filed on April 5, 2000, and in co-pending U.S. Application Serial No. 09/544,281, filed on April 6, 2000.

The chemical agent used for the second removal rate may have a high selectivity to the Ta or TaN barrier metal layer to enable complete removal of copper or copper alloy and stopping on the Ta or TaN barrier layer to minimize barrier layer removal. The selectivity of copper or copper alloy and tantalum may have a removal rate ratio of copper to tantalum of greater than about 10:1 (Cu:Ta), typically greater than about 100:1 (Cu:Ta).

The polishing end point on reaching the Ta or TaN barrier layer can be accurately determined employing a conventional optical system, such as the laser interferometer technique disclosed in U.S. Patent No. 5,893,796, the entire disclosure of which is incorporated by reference herein. The In Situ Ray Monitor (ISRM®) system marketed by Applied Materials, Inc., of Santa Clara, CA can be employed for end point detection, thereby significantly minimizing overpolishing.

The barrier layer, such as the Ta or TaN barrier layer, is then removed, under conditions such that there is a reversed selectivity among the silicon oxide dielectric layer, barrier layer and copper or copper alloy. The removal rate ratio, or selectivity, of the barrier layer, such as tantalum, may have a removal rate ratio of tantalum to dielectric layer (DL) of greater than about 10:1 (Ta:DL). An example of a suitable barrier removal process is disclosed in pending U.S. patent application Serial No. 09/401,643 filed on September 22, 1999, and in co-pending U.S. patent application Serial No. 09/569,968 filed on May 11, 2000.

Embodiments of the present invention comprise further refinernents to minimize dishing and erosion. It was found that dishing can be controlled during the first and/or second polishing steps by controlling one or more processing features or parameters.

For example, embodiments of the present invention comprise controlling the polishing pad surface at a temperature of about 50°C or less, such as about 44°C, as by reducing the platen rotating speed to no greater than 60 rpm, or the linear pad speed to no greater than 30 inches per second, thereby reducing static removal and, hence, dishing. It should be appreciated that the static removal rate should not be reduced to the extent that the polishing by-products generated during polishing can not be removed, *e.g.,* dissolved.

The polishing by-products generated during polishing can be flushed away with a high flow of chemical agent which can be recycled or recirculated to reduce the cost of consumables. The chemical agent may be delivered to the polishing pad and/or substrate surface at a flow rate of about 300 millimeters per minute or more.

It was also found that copper or copper alloy recess, thus dishing, can be reduced by reducing chemical starvation on top of the flat posts of the abrasive polishing pad that contact the copper or copper alloy surface. Conventional fixed abrasive polishing pads comprise a plurality of fixed abrasive composite elements, each comprising abrasive particles dispersed in a polymeric binder, and are often referred to as posts. Such posts typically have a height between about 30 microns and about 40 microns and, when in the form of a cylinder, a diameter of about 200 microns, providing a contact area ratio between about 10% and about 25%. The posts can be formed in the shape of various geometric configurations, such as polygons, circles and ellipsis. As used throughout this disclosure, the term diameter is intended to denote the largest cross-sectional dimension of the upper working surface of the posts confronting the surface undergoing polishing.

It was found that chemical starvation can be reduced by reducing the diameter of the posts while maintaining substantially same contact area ratio between about 10% and about 25% by increasing the number of posts. Accordingly, embodiments of the present invention comprise conducting the first and second polishing steps using fixed abrasive polishing pads comprising abrasive posts having a diameter between about 75 microns and about 150 microns, *e.g.*, about 100 microns and about 150 microns, thereby reducing chemical starvation and, hence, reducing dishing.

It was also found that dishing during the first and second polishing steps can be reduced by increasing the stiffness or rigidity of the backing sheet on which the abrasive posts are adhered. This can be achieved by selecting a backing sheet material having a suitable Young's Modulus (Modulus of Elasticity). Alternatively, the thickness of a conventional backing sheet, *e.g.*, polycarbonate backing sheet, can be increased to reduce the pad softness and, hence, reduce the pressure within the dense array, thereby reducing dishing. An example of a suitable pad is a pad having abrasive posts adhered to a backing sheet having a thickness of about 40 microns or less.

It was further found that the dishing can be decreased, as to about 600Å or less, by increasing the amount of inhibitor in the chemical agent during the second polishing step. Accordingly, embodiments of the present invention comprise conducting the second polishing step with a chemical agent including between about 0.2 wt.% and about 1.0 wt.% of an inhibitor, *e.g.,* 5-methyl benzotriazole, and other compounds containing at least one azole group.

Further improvements in dishing have been observed by increasing the concentration of the active components of the chemical agent, for example, oxidizers and chelating agents, by a factor up to about three.

Embodiments of the present invention comprise effectively removing particles generated during polishing steps (a) and (b) by flowing the chemical agent to the substrate and/or polishing pad at a flow rate above about 300 milliliters per minute, and recycling the chemical agent. Removal of such particles can also be achieved by maintaining the static removal rate at about 200Å per minute or less, such as about 150Å per minute or less.

Further improvements in reducing dishing and erosion are achieved in embodiments of the invention by applying or exposing the substrate surface and/or polishing pad to an inhibitor, such as benzotriazole, upon completing the first polishing step on one platen before initiating the second polishing step on a second platen and upon completing the second polishing step on the second platen before initiating barrier layer removal on another platen, thereby effectively removing polishing debris while avoiding static removal. Accordingly, a solution including between about 0.2 wt.% and about 1.0 wt.% of an inhibitor, *e.g.,* 5-methyl benzotriazole, and other compounds containing at least one azole group, and deionized water may be applied. The use of an inhibitor *vis-à-vis* deionized water upon terminating each of the polishing steps effectively prevents undue static removal to provide a relatively clean and low defect substrate prior to initiating the subsequent step.

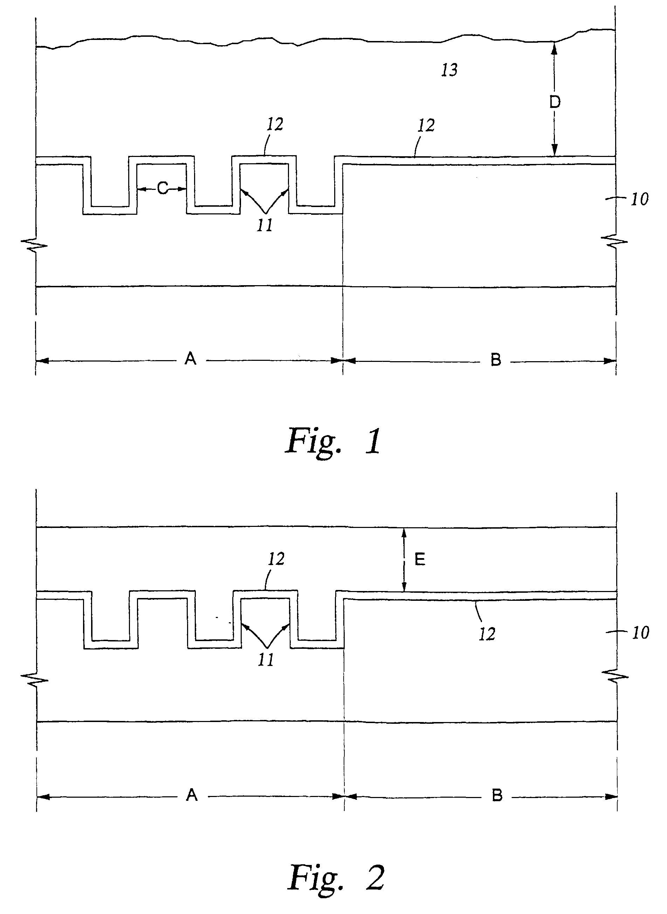

An embodiment of the present invention is schematically illustrated in Figs. 1-4, wherein similar features bear similar reference numerals. Adverting to Fig. 1, dielectric layer 10, *e.g.*, silicon oxide, is formed overlying a substrate (not shown). A plurality of openings 11 are formed in a designated area A in which a dense array of conductive lines are to be formed bordering open field B. A barrier layer 12, *e.g.*, TaN, is deposited lining the openings 11 and on the upper surface of silicon oxide dielectric layer 10. Typically, the openings 11 are spaced apart by a distance C which is less than about 1 micron, *e.g.*, less than about 0.2 micron, such as about 0.1 microns. Copper layer 13 is then deposited at thickness D between about 8,000 and about 18,000Å.

Adverting to Fig. 2, the first polishing step is conducted as to reduce the copper layer 13 to a thickness E between about 500Å and about 3,000Å at a removal rate in excess of about 5,000Å per minute.

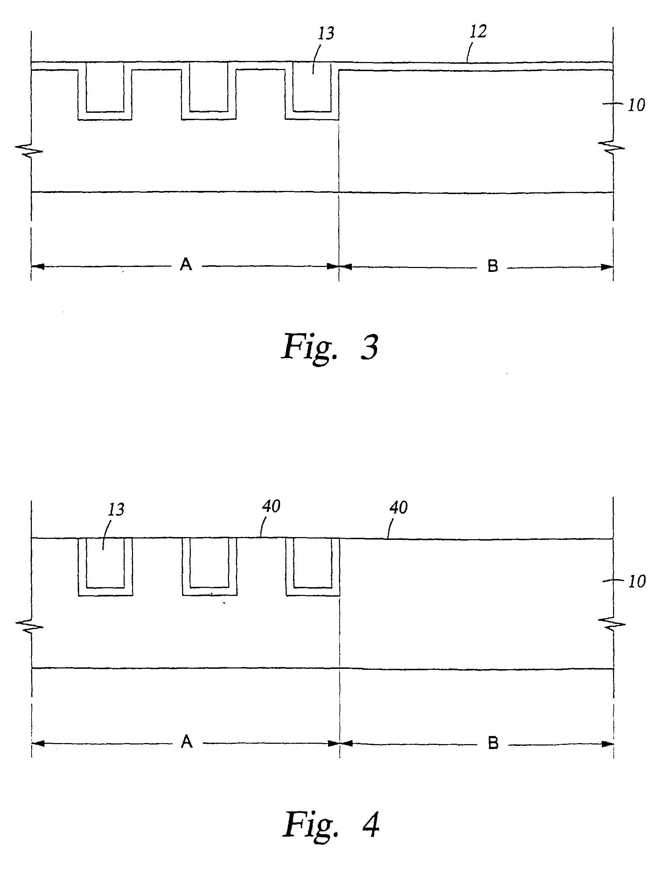

As shown in Fig. 3, the second polishing step is conducted with high selectivity to TaN barrier layer 12 stopping thereon.

As shown in Fig. 4, buffing is conducted, as with a reversed selectively to remove TaN layer 12 and buff the silicon oxide surface to remove or reduce scratching or defects, thereby completing planarization. The resulting copper interconnection structure comprises a dense array A of copper lines 13 bordered by open field B. The upper surface 40 exhibits a very high degree of planarity with virtually no erosion or dishing.

One aspect of the present invention is related to the use of a computer system to control a CMP system for planarizing a substrate. Fig. 5 depicts a general purpose computer system 100 configured to execute a software for controlling CMP system 122. The computer system 100 contains a computer 102, one or more display devices 104, and one or more input devices 106. The computer 102 contains a central processing unit (CPU) 108 such as an Intel 486 microprocessor, a memory 110 and assorted Support circuitry 112 such as a math co-processor, power supply, and the like. Such computer systems are commonly known as personal computer; however, the present invention is not limited to personal computers and can, in fact, be implemented on workstations, minicomputer, mainframes, and supercomputers. The input devices 106 used with such computers include a keyboard, a mouse, trackball and the like. The display devices 104 include computer monitors, printers and plotters.

Computer system 100 also includes a memory 110, such as a random access memory (RAM) or other dynamic storage device for storing information and instructions to be executed by CPU 108. Memory 110 also may be used for storing temporary variables or other intermediate no information during execution of instructions to be executed by CPU 108. Memory 110 further includes a read only memory (ROM) or other static storage device for storing static information and instructions for CPU 108. Memory 110 may also include a storage device, such as a magnetic disk or optical disk, provided for storing information and instructions.

The interface 124 allows the computer system 100 to communicate with the CMP system 122, specifically with CMP system controller 154. The CMP system 122 could either be a small pad or a large pad system, or a linear belt polishing system. Illustratively, a small pad system is depicted. The small pad system generally includes a base 126 for rotatably supporting a rotating plate 128 therein, and a moveable tubular polishing arm. 130 suspended over the rotating plate 126 and supported on a cross arm 132. The cross arm is maintained on the base and over the plate by opposed uprights 134, 134a which extend upwardly from the base. The rotating plate preferably includes a conformable pad fixed to its upper surface. A substrate 136, having an upper surface 138 to be polished, is placed on the polishing pad to maintain the substrate in position beneath the polishing arm as the substrate is polished. The tubular polishing arm 130, with a polishing pad 140 located over the lower open end 142 thereof, is moved generally radially across the upper surface of the substrate to perform the polishing. The polishing pad is preferably continuously moved linearly across the rotating substrate, from the edge to center, until the polishing end point is attained (*e.g.* a predefined degree of surface non-uniformity).

CMP system controller 154 controls motion of the rotating plate (or linearly moving belt) and motion of the polishing arm. Specifically, the control system controls the rotational velocity of motor 152 that is coupled to plate 128. Also, the linear motion is provided by motor 150 coupled to cross arm 132. Linear positioning mechanism 144, under control of the controller 154, control the pressure of the pad on the substrate surface through a load mechanism 148 and controls the rotation of the pad through motor 146. As such, controller 154 controls all aspects of this small pad CMP polishing system.

According to an embodiment of the present invention, planarizing a substrate surface is provided by computer system 100 controlling CMP system 122 in response to CPU 108 executing one or morc sequences of one or more instructions contained in a program 120 in memory 110. For example, instructions can be read into main memory from another computer- readable medium, such as a storage device. Execution of the sequences of instructions contained in memory 110 causes CPU 108 to perform the process step described herein. One or more processors in a multi-processing arrangement may also be employed to execute the sequences of instructions contained in memory 110. In alternative embodiments, hard-wired circuitry may be used in place of or in combination with software instructions to implement the invention. Thus, embodiments of the invention are not limited to any specific combination of hardware circuitry and software.

The term "computer-readable medium" as used herein refers to any medium that participates in providing instructions to CPU 108 for execution. Such a medium may take many forms, including, but not limited to, nonvolatile media, volatile media,-and transmission media. Non-volatile media include for example, optical or magnetic disks, such as a storage device. Volatile media include dynamic memory, such as a main memory. Transmission media include coaxial cables, copper wire and fiber optics, including the wires that comprise a system bus. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to CPU 108 for execution. For example, the instructions may be initially be borne on a magnetic disk of a remote computer. The remote computer can load the instructions into its dynamic memory and send the instructions over a telephone line using a modem. A modem (not shown) local to computer system 100 can receive the data on the telephone line and use an infrared transmittal to convert the data to an infrared signal. An infrared detector as an input device 106 can place the data on the system bus, which carries the data to memory 110, from which CPU 108 retrieves and executes the instructions. The instructions received at memory 110 may optionally be stored on storage device either before or after execution by CPU 108.

The present invention is applicable to planarizing during various stages of semiconductor manufacturing. The present invention enjoys particular applicability in the manufacture of high density semiconductor devices with metal features in the deep submicron range.

Only the preferred embodiment of the present invention and but a few example of its versatility are shown and described in the present disclosure. It is to be understood that the present invention is capable of use in various other combinations and environments and is capable of changes and modifications within the scope of the inventive concept as expressed herein.

## Claims

1. A method of planarizing a substrate surface containing a copper or copper alloy layer disposed on a barrier layer comprising:
(a) polishing the substrate surface on a first platen to reduce a copper or copper alloy layer at a first removal rate; and
(b) polishing the substrate on a second platen to remove the copper or copper alloy layer at a second removal rate less than the first removal rate.

2. A method as claimed in claim 1, wherein
the first removal rate greater than about 5,000 Å per minute; and
the second removal rate is between about 250 Å per minute and about 3,000 Å per minute.

3. A method as claimed in claim 1 or claim 2, wherein step (b) is performed at a selectivity of copper:barrier layer of greater than about 100:1.

4. A method as claimed in claim 3, wherein step (b) is performed under conditions such that dishing within the dense array is about 600Å or less.

5. A method as claimed in any of claims 1 to 4, wherein steps (a) and (b) are performed on rotating, stationary, or linear fixed abrasive polishing pads or belts mounted on the first and second platens, respectively, using abrasive free chemical agents.

6. A method as claimed in claim 5, wherein the first and second platens are rotated during steps (a) and (b) by at less than about 60 rpm or the first and second belts disposed on the first and second platens, respectively, are moved linearly at a rate of less than about 30 inches per second.

7. A method as claimed in claim 5 or claim 6, further comprising cleaning the polishing pads by removing debris and polishing by-products between each substrate.

8. A method as claimed in any of claims 5 to 7, further comprising recycling the chemical agents.

9. A method as claimed in any of claims 5 to 8, wherein the chemical agents are delivered to the polishing pad or the substrate surface at a flow rate of about 300 milliliters per minute or more.

10. A method as claimed in any of claims 5 to 9, wherein a static removal rate of the substrate surface is about 200Å per minute or less.

11. A method as claimed in any of claims 5 to 10, further comprising exposing the polishing pad or the substrate surface to an inhibitor after completing step (a) and prior to initiating step (b).

12. A method as claimed in any of claims 5 to 11, further comprising:
exposing the polishing pad or the substrate surface to an inhibitor after completing step (a) and prior to initiating step (b);
exposing the polishing pad or the substrate surface to an inhibitor after completing step (b); and
recirculating the chemical agents.

13. A method as claimed in claim 12, further comprising:
controlling dishing in the dense array during steps (a) and (b) by:
rotating the first and second platens, respectively, at less than about 60 rpm or linearly moving the first and second belts at about 30 inches per second, wherein the polishing pad temperature is about 50°C or less.

14. A method as claimed in claim 12 or claim 13, further comprising:
controlling the removal of particles during steps (a) and (b) by:
delivering the chemical agent to the polishing pad or the substrate surface at a flow rate of at least about 300 milliliters per minute and
controlling the amount of inhibitor in the chemical agent to provide a static removal rate of the substrate surface of about 200Å per minute or less.

15. A method as claimed in any of claims 12 to 14, further comprising:
controlling dishing in the dense array during steps (a) and (b) by:
rotating the first and second platens, respectively, at less than about 60 rpm or linearly moving the first and second belts at about 30 inches per second, wherein the polishing pad temperature is about 50°C or less; and
controlling the removal of particles during steps (a) and (b) by:
delivering the chemical agent to the polishing pad or the substrate surface at a flow rate of at least about 300 milliliters per minute and
controlling the amount of inhibitor in the chemical agent to provide a static removal rate of the substrate surface of about 200Å per minute or less.

16. A method as claimed in any of claims 5 to 15, wherein the polishing pad or belt temperature is about 50°C or less.

17. A method as claimed in any of claims t to 16, wherein the fixed abrasive polishing pad comprising abrasive posts having a diameter between about 75 microns and about 150 microns and contact area ratio between about 10% and about 25% with the substrate surface.

18. A method as claimed in claim 17, wherein the abrasive posts are adhered to a backing sheet having a thickness of about 40 micron or less.

19. A method as claimed in any of claims 1 to 18, wherein the second polishing process includes a chemical agent having between about 0.2 wt.% and about 1.0 wt.% of an inhibitor.

20. A method as claimed in any of claims 1 to 19, further comprising removing the barrier layer on a third platen.

21. A method as claimed in claim 20, wherein the barrier layer comprises tantalum (Ta) or tantalum nitride (TaN) and is disposed on a dielectric material.

22. A method as claimed in claim 20 or claim 21, further comprising exposing the polishing pad or the substrate surface to an inhibitor after completing step (b) and prior to initiating removing the barrier layer.

23. A method as claimed in any of claims 20 to 22, wherein the barrier layer is removed from the substrate surface at a ratio of barrier layer to dielectric layer of greater than about 10:1.

24. A method as claimed in any of the preceding claims, wherein a computer based control system is used to sequence and control the steps of the method of planarizing the substrate surface.

25. A computer-readable medium bearing instructions for planarizing a substrate surface, the instructions arranged, when executed by one or more processors, to cause the one or more processors to control a polishing system to perform the steps of:
(a) polishing the substrate surface on a first platen to reduce a copper or copper alloy layer at a first removal rate; and
(b) polishing the substrate on a second platen to remove the copper or copper alloy layer at a second removal rate, less than the first removal rate.

26. A computer readable medium as claimed in claim 25, wherein said instructions are arranged for conducting step (a) at the first removal rate greater than about 5,000 Å per minute; and conducting step (b) at the second removal rate between about 250 Å per minute and about 3,000 Å per minute.

27. A computer readable medium as claimed in claim 25 or claim 26, wherein said instructions are arranged for performing step (b) at a selectivity of copper:barrier layer of greater than about 100:1.

28. A computer readable medium as claimed in claim 27, wherein said instructions are arranged for performing step (b) under conditions such that dishing within the dense array is about 600Å or less.

29. A computer readable medium as claimed in any of claims 25 to 27, wherein said instructions are arranged for performing steps (a) and (b) on a rotating, stationary, or linear fixed abrasive polishing pad mounted on the first and second platens, respectively, using abrasive free chemical agents.

30. A computer readable medium as claimed in claim 29, wherein said instructions are arranged for rotating the first and second platens during steps (a) and (b) by at less than about 60 rpm or the first and second belts disposed on the first and second platens, respectively, are moved linearly at a rate of less than about 30 inches per second.

31. A computer readable medium as claimed in claim 30, wherein said instructions are arranged for delivering the chemical agents to the polishing pad or the substrate surface at a flow rate of about 300 milliliters per minute or more.

32. A computer readable medium as claimed in any of claims 29 to 31, wherein said instructions are arranged for recycling the chemical agents.

33. A computer readable medium as claimed in any of claims 29 to 32, wherein said instructions are arranged for controlling the removal of particles during steps (a) and (b) by controlling the static etching rate up of the substrate surface up to about 200Å per minute or less by controlling the amount of inhibitor in the chemical agent.

34. A computer readable medium as claimed in any of claims 29 to 33, wherein said instructions are arranged for exposing the polishing pad or the substrate surface to an inhibitor after completing step (a) and prior to initiating step (b).

35. A computer readable medium as claimed in any of claims 29 to 33, wherein said instructions are arranged for exposing the polishing pad or the substrate surface to an inhibitor after completing step (b) and prior to initiating removing the barrier layer.

36. A computer readable medium as claimed in any of claims 29 to 35, wherein said instructions are further arranged for
exposing the polishing pad or the substrate surface to an inhibitor after completing step (a) and prior to initiating step (b);
exposing the polishing pad or the substrate surface to an inhibitor after completing step (b); and
recirculating the chemical agents.

37. A computer readable medium as claimed in any of claims 29 to 36, wherein said instructions are arranged for maintaining the polishing pad or belt temperature is about 50°C or less.

38. A computer readable medium as claimed in any of claims 25 to 37, wherein said instructions are arranged for controlling dishing in the dense array during steps (a) and (b) by: rotating the first and second platens, respectively, at less than about 60 rpm or linearly moving the first and second belts at about 30 inches per second, wherein the polishing pad temperature is about 50°C or less.

39. A computer readable medium as claimed in any of claims 25 to 38, wherein said instructions are arranged for controlling the removal of particles during steps (a) and (b) by:
delivering the chemical agent to the polishing pad or the substrate surface at a flow rate of at least about 300 milliliters per minute and
controlling the amount of inhibitor in the chemical agent to provide a static removal rate of the substrate surface of about 200Å per minute or less.

40. A computer readable medium as claimed in any of claims 25 to 37, wherein said instructions are arranged for:
controlling dishing in the dense array during steps (a) and (b) by:
rotating the first and second platens, respectively, at less than about 60 rpm or linearly moving the first and second belts at about 30 inches per second, wherein the polishing pad temperature is about 50°C or less; and
controlling the removal of particles during steps (a) and (b) by:
delivering the chemical agent to the polishing pad or the substrate surface at a flow rate of at least about 300 milliliters per minute and
controlling the amount of inhibitor in the chemical agent to provide a static removal rate of the substrate surface of about 200Å per minute or less.

41. A computer readable medium as claimed in any of claims 25 to 40, wherein said instructions are further arranged for removing the barrier layer on a third platen.

42. A computer readable medium as claimed in claim 41, wherein said instructions are arranged for removing the barrier layer from the substrate surface at a ratio of barrier layer to dielectric layer of greater than about 10:1.

43. A computer readable medium as claimed in any of claims 25 to 42, wherein said instructions are arranged for CMP a plurality of substrates and cleaning the polishing pads by removing debris and CMP by-products between each substrate.

44. The computer-readable medium according to any of the preceding claims, wherein a computer based control system is used to sequence and control the steps of the computer-readable medium bearing instructions for planarizing the substrate surface.
